# EUROPEAN PATENT SPECIFICATION

(11) **EP 3 965 207 B1**
(45) Date of publication and mention of the grant of the patent: **24.12.2025**
(21) Application number: 20194891.6
(22) Date of filing: 07.09.2020
(51) Int. Cl.: H01M 10/42, H01M 10/6556, H01M 50/249, H01M 50/284, H01M 50/298, H01M 10/46, H01M 10/48

(54) **BATTERY SYSTEM WITH ADVANCED BATTERY DISCONNECTING UNIT**
BATTERIESYSTEM MIT VERBESSERTER BATTERIETRENNEINHEIT
SYSTÈME DE BATTERIE AVEC UNITÉ DE DÉCONNEXION DE BATTERIE AVANCÉE

(43) Date of publication of application: 09.03.2022
(73) Proprietor: Samsung SDI Co., Ltd., Yongin-si, Gyeonggi-do 17084 (KR)
(72) Inventor: ERHART, Michael, 8054 Seiersberg-Pirka (AT); HICHENS, Joshua, 8052 Graz (AT)
(74) Representative: Gulde & Partner

(56) References cited:
- EP-A2- 2 362 463
- US-A1- 2019 214 606
- US-A1- 2019 273 288
- US-A1- 2020 127 350

## Description

### Field of the Invention

The present invention relates to a battery system, wherein the battery system comprises an advanced battery disconnecting unit, BDU, and to an electric vehicle including such a battery system.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery, EVB, or traction battery is a battery used to power the propulsion of battery electric vehicles, BEVs. Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

Battery modules can be constructed either in block design or in modular design. In block designs each battery is coupled to a common current collector structure and a common battery management system and the unit thereof is arranged in a housing. In modular designs, pluralities of battery cells are connected to form submodules and several submodules are connected to form the battery module. In automotive applications, battery systems often consist of a plurality of battery modules connected in series for providing a desired voltage. Therein, the battery modules may comprise submodules with a plurality of stacked battery cells, each stack comprising cells connected in parallel that are connected in series (*XpYs*) or multiple cells connected in series that are connected in parallel (*XsYp*)*.*

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between the battery modules.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually comprise a battery system manager, BSM, for obtaining and processing such information on system level and further a plurality of battery module managers, BMMs, which are part of the system's battery modules and obtain and process relevant information on system level. Particularly, the BSM usually measures the system voltage, the system current, the local temperature at different places inside the system housing, and the insulation resistance between live components and the system housing. Additionally, the BMMs usually measure individual the cell voltages and the temperatures of the battery modules.

In case of an abnormal operation state, a battery pack shall usually be disconnected from a load connected to a terminal of the battery pack. Therefore, battery systems further comprise a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU by using low current paths based on the feedback received from the BDU. The main functions of the BDU may thus include controlling current flow between the battery pack and the electrical system and current sensing. The BDU may further manage additional functions like external charging and pre-charging.

For example, US 2019/0214606 A1 discloses a battery module including a solid state switch which avoids the requirement of different cooling systems in a battery module while additional expenses in the production of the battery modules are reduced. US 2019/0273288 A1 describes a method and a system for cooling for a battery module with an integrated power electronics system, in which method and system the thermal coupling of the power electronics system to a heat discharge system from the battery module is taken into consideration. EP 2 362 463 A2 relates to a high-current power source apparatus comprising a cooled configuration which can be achieved by providing a cooling plate with a coolant pipe for each battery block, and each battery stack can be disposed on a cooling plate. US 2020/0127350 A1 discloses a battery pack including battery cells, each including a first end portion and a second end portion that are opposite each other in a length direction of the respective battery cell; a case having an accommodation space in which the battery cells and a cooling fluid to cool the battery cells are configured to be accommodated, the case including first and second covers that respectively cover the first and second end portions of the battery cells; first and second tab plates respectively on the first and second covers and electrically connected to the first and second end portions of the battery cells; a circuit board on the first tab plate; and a first lead and a second lead through which the first and second tab plates are electrically connected to the circuit board, the first and second leads being connected to a first side portion of the circuit board.

During the usage of the batteries the components of BDU get heated and release heat energy, hence, the components of the BDU need to be cooled. Usually, the BDU components are air cooled within the closed or partly opened housing inside the battery pack. This however, requires longer busbars to provide enough cooling surface for the electric components such as relay and fuses. The longer busbars require a much wider cross section of the busbars to keep the resistance and losses as low as possible. Furthermore, when realizing higher currents for fast charging much more power loss and internal heating of the BDU components is caused, particularly in the case of long and wide busbars.

It is thus an object of the present invention to overcome or reduce at least some of the drawbacks of the prior art and to provide a battery system that comprises an advanced layout of the BDU and its components, which allows for an improved cooling of the components of the BDU in an efficient manner.

### Description of the Invention

The invention is defined by the subject matter of claim 1.

Embodiments of the present disclosure seek to reduce or solve the problems existing in the prior art. In particular, a battery system for a vehicle is provided, the battery system comprising a high voltage system, HV system, with a plurality of connected rechargeable battery cells. Preferably, the plurality of connected rechargeable battery cells is used as at least one battery module formed of the plurality of battery cells coupled in series and/or in parallel. Further preferred, the at least one battery module may comprise submodules with a plurality of stacked rechargeable battery cells. In context of the present disclosure high voltage, HV, refers to a voltage sufficient for propelling power driving of an electric vehicle as usually provided by battery systems for electric vehicles. Exemplarily, the high voltage may be 48 V, 100 V, 300 V, or even more.

According to the present disclosure, the battery system further comprises a battery disconnecting unit, BDU, comprising a carrier plate and comprising BDU relays to switchably open or close a HV line of the HV system, wherein the HV line is at least partially integrated into the carrier plate and a BDU control unit adapted to control the BDU relays.

The HV line is the connection between the terminals of the plurality of connected rechargeable battery cells (or module terminals) and the terminals of the battery system, wherein the latter are configured to be contacted by external loads, such as e.g., a motor. The HV line preferably comprises a plurality of busbars. At least partially, the HV line is integrated into the carrier plate wherein the carrier plate comprises an electrically non-conductive material with a high melting point, particularly a melting point above 200°C, preferably above 300°C and further preferably above 350°C. Preferably the material has further a sufficient thermal conductivity, particularly a thermal conductivity above 0.1 W/(m*K), preferably above 1 W/(m*K) and further preferably above 5 W/(m*K). Particularly preferred the insulating material is a plastic material and comprises a thermally conducting filler, such as in a ceramic or glass filled plastic material.

The BDU control unit is configured to control the relays in the BDU based on a control signal, which itself might be based on measurements of the battery system or may be received from a vehicle control unit (e.g., in case of a crash). The BDU control unit is thus configured to disconnect the plurality of battery cells from the battery system terminals in case of an abnormal operation state. In other words, the BDU is configured to selectively set the HV electric path between the battery cell/module terminals and the battery system terminals either conductive or non-conductive.

According to the present disclosure, the battery system further comprises a liquid cooling plate, wherein the liquid cooling plate is arranged on a first side of the carrier plate. The first side of the carrier plate may be a flat side of the carrier plate and the liquid cooling plate may be arranged on the first side such that a flat side of the liquid cooling plate contacts the first side. Preferably, the flat side of the liquid cooling plate contacts the first side of the carrier plate in a thermally conductive manner such that the liquid cooling plate cools the carrier plate and thus the integrated parts of the HV line. The parts of the HV line that are integrated into the carrier plate may comprise the plurality of busbars.

The liquid cooling plate of the battery system advantageously enables the use of much smaller busbars for the HV line, which lowers the resistance and losses of the BDU. Further, as the HV line is at least partially integrated into the carrier plate an electric and physical insulation between the busbars and the liquid cooling plate is improved and a risk for electric malfunctions due to leakage of cooling liquid is reduced. Furthermore, the battery system of the present disclosure has a reduced overall volume and weight compared to a typical BDU of a state of the art battery system. This is advantageously achieved through the use of smaller busbars, which is itself enabled by the use of more efficient cooling methods that is the liquid cooling plate. By more effectively cooling the BDU, the battery system can be advantageously used for higher load applications, e.g., fast charging. In general, as the BDU elements, e.g. the busbars, are actively cooled by the liquid cooling plate in a highly efficient manner, higher loads can be applied to the battery system via the BDU.

According to another aspect of the present disclosure, the liquid cooling plate comprises a cavity that is configured to conduct a cooling liquid. The cavity is preferably a closed cavity within the liquid cooling plate that fluidly connects a coolant inlet and a coolant outlet of the liquid cooling plate. In other words, a coolant introduced into the cavity via the coolant inlet can flow through the cavity towards the coolant outlet and can be discharged from the cavity via the coolant outlet.

Further preferred, the liquid cooling plate is adapted such that the first side of the carrier plate form-fits on the liquid cooling plate. In other words, the first side of the liquid cooling plate and the first side of the carrier plate are shaped to fit together. The cavity of the liquid cooling plate preferably forms at least one, preferably a plurality of, flow channel(s) for the cooling liquid. Preferably, the cooling liquid may be water. Further preferred, the cooling liquid may be another suitable liquid cooling medium. Preferably, the liquid cooling plate may be part of a cooling system of the battery system. Further preferred, the liquid cooling plate may be autonomous.

According to a preferred embodiment of the battery system, the battery system further comprises a low voltage system, LV system, with an operating voltage lower than an operating voltage of the HV system, wherein the BDU control unit is assembled with the LV system. In other words, the BDU control unit receives its supply power from the LV system. Exemplarily, the LV operating voltage may be 12 V or another voltage used from a low voltage system of the battery system and/or the vehicle. Preferably, the LV system further comprises a battery system manager, BSM, of the battery system and a plurality of sensors. In other words, the LV system of the battery system is designed to monitor the status of the battery system, e.g. by measuring the system voltage, the system current and/or the local temperature at different places inside the battery system, to process the measured data and send signals to battery components based on the processed data. For example, in case of an abnormal operation state of the battery system, the LV system is able to detect the abnormalities in the measured data and to send a signal to the BDU relays, with the BDU control unit, to disconnect the HV line. Further preferred the BSM is configured to communicate with external control units, such as vehicle control units, e.g., to receive a disconnect request signal from an external control unit and, in response to a received disconnect request signal, to send a disconnect signal to set BDU relays non-conductive.

According to another preferred embodiment, the BDU further comprises high-voltage, HV, components, including for example the BDU relays, and low-voltage, LV, components, including for example the BDU control unit. According to the invention, the HV components and the LV components of the BDU are arranged on a second side of the carrier plate, wherein the second side of the carrier plate is opposite to the first side of the carrier plate.

Preferably, the HV components and the LV components of the BDU are integrated and/or fixed to the second side of the carrier plate. By mounting the HV and LV components of the BDU to the second side of the carrier plate, the components also get cooled by the liquid cooling plate because of the material of the carrier plate with sufficient thermal conductivity. The inventive cooling of the LV components and especially the HV components of the BDU, such as relays, leads advantageously to an improved lifetime of the BDU components. Exemplarily, the HV components and/or LV components are configured as SMDs.

According to a preferred embodiment, the HV-line comprises a plurality of busbars, wherein the busbars are at least partially integrated into the carrier plate. A busbar is a strip or bar for local high current power distribution. Preferably the plurality of busbars is made of metal. Particularly preferred, the busbars comprise a stamped grid copper. However, the busbars may also be formed from aluminum or a suitable alloy.

In a particularly preferred embodiment, the HV components of the BDU comprise a high voltage printed circuit board, HV-PCB disposed on the second side of the carrier plate, including a conductive layer connected to the HV-line, and the LV components of the BDU comprise a low voltage printed circuit board, LV-PCB, wherein the HV components and the LV components of the BDU are disposed on the HV-PCB. Preferably, the HV-PCB is at least partially integrated into the carrier plate. Alternatively preferred, the HV-PCB comprises a first side and an opposite second side, wherein the first side of the HV-PCB is disposed on the second side of the carrier plate and the HV components and the LV components of the BDU are disposed on the second side of the HV-PCB. In other words in the alternatively preferred embodiment the HV-PCB and the carrier plate are two different components that are arranged on top of each other but not integrated into each other.

The HV-PCB is preferably configured to replace a HV wiring harness, which is typically used in the current art. In other words, the HV-PCB provides the electric connections between the HV-line (also at least partially integrated in the carrier plate) and the BDU control unit, e.g., for performing measurements, in an integrated manner. The BDU of the present disclosure thus preferably is a fully integrated HV component for conducting a HV between the battery cells and system terminals and for allowing measurement access to the HV line. Such measurement access is advantageously provided by the at least one conductive layer.

The invention hence simplifies the current art in an advantageous manner. By using a HV-PCB instead of a HV wiring harness, the number of parts has been reduced. Furthermore, the removal of a wiring harness advantageously simplifies the assembly process, as wiring harnesses are not typically suitable for automated assembly.

According to a further preferred embodiment, the HV-PCB further comprises a pre-charge trace-resistor and the pre-charge trace resistor comprises a conductive trace. The conductive trace may also be formed by a conductive layer of the HV-PCB. By using a pre-charge trace resistor on the PCB, the invention replaces one or many off-the-shelf pre-charge resistor products and thus further simplifies the assembly process advantageously. In other words, the conductive layer of the HV-PCB may not only provide measurement access to the HV-line but may even form electric components required to perform pre-charging of the battery modules. The HV-PCB may further comprise other conductive traces, e.g., for forming an integrated shunt resistor or voltage divider.

According to another preferred embodiment, the HV-PCB further comprises a shunt. In the battery system of the present disclosure there is active cooling of the shunt, which advantageously leads to an increased accuracy for the current measurement, as the temperature of the shunt can be regulated using active cooling which minimizes the error.

Further preferred, the LV-PCB comprises first contacting means and the HV-PCB comprises second contacting means configured for receiving the first contacting means for establishing a data connection between the LV-PCB and the HV-PCB. Preferably, the second contacting means are some kind of socket and the first contacting means a corresponding kind of plug that fits into the socket or vice versa. In other words, the contacting means are the two parts of a PCB connector, such as e.g., a Peripheral Component Interconnect Express, PCle. In this aspect of the present disclosure, the HV-PCB is utilized like a high-voltage-motherboard and the LV-PCB is preferably mounted to the HV-PCB via a plug connection, which advantageously simplifies the assembly process and an eventual replacement of the LV-PCB.

According to another aspect of the present disclosure, the HV-PCB comprises busbar connection areas, wherein each busbar connection area exposes a portion of one of the plurality of busbars. The busbar connection areas may be formed as openings of the HV-PCB, e.g., for partially exposing busbars that are integrated (embedded) into the carrier plate. Advantageously, BDU components that are configured to be integrated into the HV line, like fuses or relays, can be simply connected between two busbars by being applied onto the busbar connection areas, i.e., two busbar connection areas. Hence, also in this respect the HV-PCB is utilized like a high-voltage-motherboard, which advantageously simplifies the assembly process and an eventual replacement of busbar connecting BDU components, such as relays or fuses, which can be mounted to the HV-PCB via a plug connection. Preferably the busbar connection areas expose a portion of a busbar that is configured for receiving a connection element of a BDU component.

Preferably, the BDU components comprise at least one Pyrofuse, at least one relay and/or melting fuse. A pyrofuse is a pyrotechnic, fast-acting safety switch, which provides rapid battery isolation and is also called pyrotechnical safety switch, PSS. The invention advantageously uses a PSS to replace at least one melting safety switch used in the current art. The at least one PSS, relay and/or melting fuse is preferably surface mounted to the HV-PCB. Particularly preferred, at least one relay and/or fuse is surface mounted to the HV-PCB such as to connect two busbar connection areas to each other. The busbars are a part of the HV line of the battery system that connects the terminals of the plurality of connected rechargeable battery cells with the battery system terminals. By connecting two busbar connection areas with at least one relay and/or fuse it is ensured, that in case of an abnormal operation state of the battery system, the HV line and thus the connection between the battery cells and the battery system terminal is disconnected.

According to another preferred embodiment, the HV-PCB further comprises a plurality of data lines connecting the second contacting means and at least one mounting socket formed on the second side of the carrier plate. Preferably, the at least one mounting socket is configured to receive a HV component of the BDU, such as a switchable relay or the like, which is controlled by the LV component of the BDU, such as the BDU control unit. The data lines can thus provide an electric connection between the BDU control unit, e.g., formed on the LV-PCB connected to the second contacting means, and the HV BDU components connected to the mounting sockets. Further preferred the mounting sockets are disposed adjacent at least one busbar connection area, e.g. in order to allow a relay to be connected to the data lines for receiving switching signals and to the HV line for setting its conductivity.

Further preferred, at least one sensor may be mounted to a mounting socket of the HV-PCB. Hence, a LV-PCB connected with its first contacting means to the second contacting means is able to receive data like current, voltage or temperature data from the at least one sensor via respective mounting sockets and data lines. With the received data a connected LV-PCB is able to monitor the status of the BDU, in particular the status of the BDU component connected to the mounting socket.

In a particularly preferred embodiment of the present disclosure, the BDU further comprises a thermally conducting and electrically isolating interface material layer arranged between the liquid cooling plate and the carrier plate and/or between the carrier plate and the HV-PCB. A thermally conductive and electrically insulating thermal interface material layer, TIM, has a high thermal conductivity but low electrical conductivity. This situation may occur when in insulators with low electrical conductivity, atomic vibrations of the phonons are very efficient at transporting heat. This is because heat is carried by both phonons and electrons, while free electrons are required for high electrical conductivity. Preferably the TIM has a thermal conductivity above 0.1 W/(m*K), preferably above 0.5 W/(m*K) and further preferably above 1 W/(m*K). Materials like polymorphs of boron nitride and silicon carbide, aluminum nitride or aluminum nitride layer sandwiched between two copper layers may be used as TIM. However, other materials, which could be used as TIM, may be used by a person skilled in the art.

According to another aspect of the present disclosure, a vehicle including a battery module of the present disclosure as defined above is provided. Preferred embodiments of the vehicle correspond to preferred embodiments of the battery module as also described above.

Further aspects of the present disclosure could be learned from the dependent claims or the following descriptions of the drawings.

### Brief Description of the Drawings

Features will become apparent to those of ordinary skill in the art by describing in detail exemplary embodiments with reference to the attached drawings in which:
- Fig. 1: illustrates a perspective view of a battery cell according to an embodiment;
- Fig. 2: illustrates a perspective view of a conventional battery module;
- Fig. 3: illustrates a schematic top view of a battery system according to an embodiment;
- Fig. 4a: illustrates a perspective view of a BDU according to an embodiment; and
- Fig. 4b: illustrates a top view of the BDU shown in Fig. 4a according to an embodiment.

### Detailed Description of the Drawings

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present invention should not be construed as being limited thereto.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value. Further, the use of "may" when describing embodiments of the present invention refers to "one or more embodiments of the present invention."

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

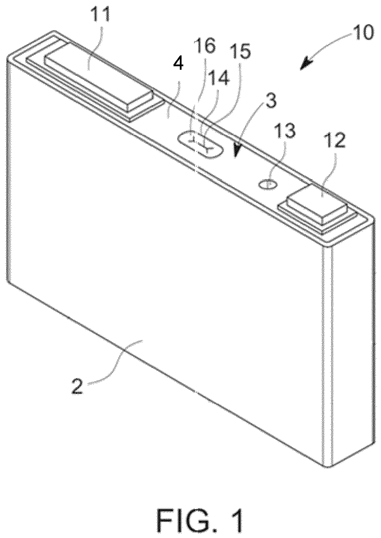

Fig. 1 is a perspective view illustrating a battery cell according to an exemplary embodiment.

As shown in Fig. 1, a battery cell 10 according to an embodiment may include an electrode assembly, and a case 2 for accommodating the electrode assembly, the case 2 containing an electrolyte. The electrolyte may comprise a lithium salt, such as LiPF6 or LiBF4, and an organic solvent, such as EC, PC, DEC, or EMC. The electrolyte may be in a liquid, solid, or a gel state. The battery cell 10 may also include a cap assembly 3 for sealing an opening of the case 2. The battery cell 10 will be described as a non-limiting example of a lithium ion secondary battery configured to have a prismatic shape.

The case 2 may be configured to have a substantially cuboidal shape to form a space for accommodating the electrode assembly, and an opening may be formed at one side of the case 2. The case 2 may be formed of a metal, such as aluminum. The cap assembly 3 may include a cap plate 4 for covering the opening of the case 2 by being bonded to the case 2, and may include a positive terminal 11 (first terminal) and a negative terminal 12 (second terminal), which are externally protruded from the cap plate 4 to be electrically connected to the positive electrode and the negative electrode, respectively. The cap plate 4 may include an injection hole 13 and a vent hole 14 that communicate with an interior of the cap assembly 3. The injection hole 13 may be configured to allow injection of the electrolyte, and a sealing cap may be mounted thereon or therein. Further, a vent member 16 including a notch 15, which may be opened due to a predetermined pressure, may be mounted to or in the vent hole 14.

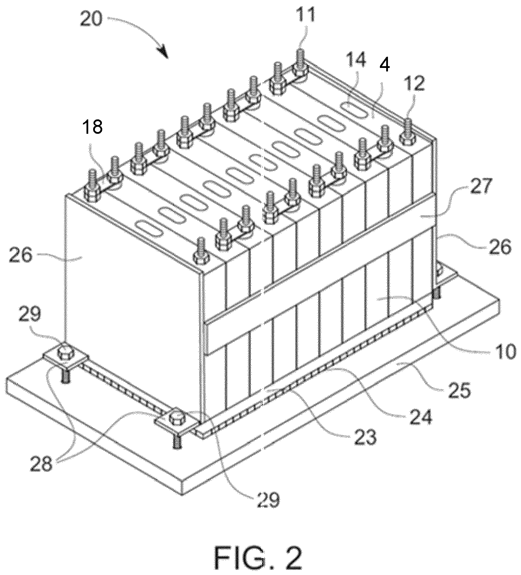

Referring to Fig. 2, an exemplary embodiment of a battery module 20 includes a plurality of battery cells 10, e.g. as illustrated in Fig. 1, aligned in one direction and a heat exchange member 23 provided adjacent to a bottom surface of the plurality of battery cells 10. In addition, an elastic member 24 made of rubber or other elastic materials may be interposed between a support plate 25 and the heat exchange member 23. A pair of end plates 26 are provided to face wide surfaces of the battery cells 10 at the outside of the battery cells 10, and a connection plate 27 is configured to connect the pair of end plates 26 to each other thereby fixing the plurality of battery cells 10 together. Fastening portions 28 on both sides of the battery module 20 are fastened to the support plate 25 by bolts 29.

In the battery module 20, each battery cell 10 is a prismatic (or rectangular) cell, the wide flat surfaces of the cells 10 being stacked together to form the battery module 20. The positive and negative electrode terminals 11 and 12 of neighboring battery cells 10 are electrically connected through a battery module busbar 18, and the busbar 18 may be fixed by a nut or the like. Hence, the battery module 20 may be used as power source unit by electrically connecting the plurality of battery cells 10 as one bundle.

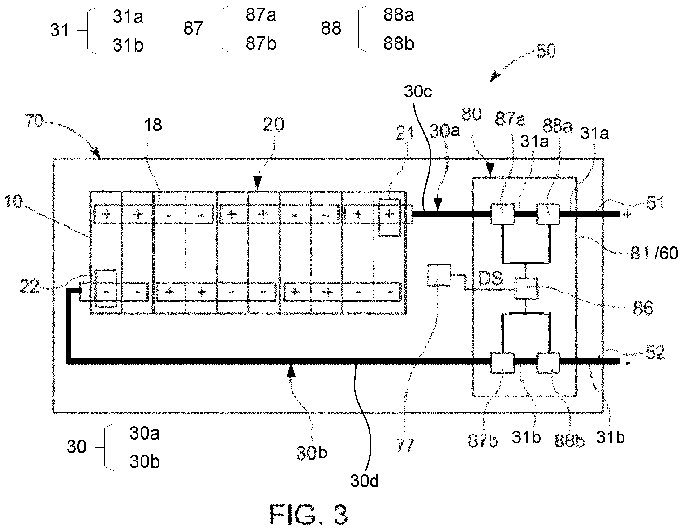

Fig. 3 is a top view illustrating a battery system 50 according to an embodiment.

It is to be noted, that the Fig. 3 is meant to provide a better understandability of the battery system 50 of the present disclosure, especially the electrical connection between a battery module 20 and a BDU (Battery Disconnect Unit) 80 of the battery system 50. The battery system 50 may be utilized in an electric vehicle and thus the battery system 50 may only have a single level.

The battery system 50 comprises the battery module 20. As shown in Fig. 3, the battery module 20 comprises ten aligned battery cells 10 that are stacked in a stacking direction with their wide side surfaces facing each other. The plurality of battery cells 10 are interconnected by means of the respective busbars 18 between module terminals 21 and 22, namely a first module terminal 21 and a second module terminal 22.

The battery system 50 further comprises the BDU (Battery Disconnect Unit) 80 comprising a carrier plate 81 with a liquid cooling plate 60 underneath it. Furthermore, the BDU 80 comprises BDU elements. The BDU elements comprise a BDU control unit 86, two BDU relays 87, namely, a first BDU relay 87a and a second BDU relay 87b, two BDU fuses 88, namely, a first BDU fuse 88a and a second BDU fuse 88b, and a plurality of BDU busbars 31, namely, first BDU busbars 31a and second busbars 31b. The BDU control unit 86 is configured to control the BDU relays 87a and 87b, particularly to set a conductivity of the BDU relays 87a and 87b. The BDU control unit 86 is further configured to control the BDU fuses 88a and 88b, particularly to monitor a state of the BDU fuses 88a and 88b. Particularly, the BDU control unit 86 is configured to receive a signal indicative of a malfunction of the battery system 50 and/or indicating that disconnecting the at least one battery module 20 from a load is required and, in response to receiving such signal, is configured to control the further BDU elements, such as the BDU relays 87a and 87b and BDU fuses 88a and 88b, to disconnect the at least one battery module 20 from the respective system terminal (and consequently a downstream load). The functions of such components as part of a BDU are known to the skilled person. Furthermore, It is to be understood, that the presented BDU elements are not limited to the number of BDU relays and BDU fuses, as a person skilled in the art could use any other number of BDU relays and BDU fuses, for example, only one BDU fuse instead of two.

The first module terminal 21 of the battery module 20 is connected to a first (positive) battery system terminal 51 of the battery system 50 via a first HV line 30a of a HV line comprising a first high current cable 30c and the first BDU busbars 31a, the first BDU relay 87a and the first BDU fuse 88a. The second module terminal 22 of the battery module 20 is connected to a second (negative) battery system terminal 52 of the battery system 50 via a second HV line 30b of the HV line comprising a second high current cable 30d and the second BDU busbars 31b, the second BDU relay 87b and the second BDU fuse 88b. A high current path is formed by the HV line 30, comprising the BDU busbars 31a, 31b, and the battery module busbars 18 and is presented in Fig. 3 with thick lines. The HV line 30 and the BDU busbars 31a, 31b connect the module terminals 21, 22 of the battery module 20 of the battery system 50 with system terminals 51, 52, respectively, wherein these connections are provided via the BDU relays 87a and 87b and BDU fuses 88a and 88b, respectively.

The battery system 50 may further comprise a battery system manager, BSM, 77 located inside a housing 70 of the battery system 50 as shown in Fig. 3. The BSM 77 is configured to monitor the whole battery system 50, e.g. by measuring system voltage, system current, local temperature at different places inside the housing 70, and the insulation resistance between live components and the housing 70. The BSM 77 may determine the presence of an abnormal condition in the battery system 50 and perform or control to perform at least one countermeasure associated with the determined abnormal condition, such as e.g. transmit a warning signal to the vehicle's driver. Particularly, the BSM 77 transmits a disconnect signal DS to the BDU control unit 86 that, in response to receiving the disconnect signal DS, controls the BDU elements, namely, the BDU relays 87 and the BDU fuses 88 to disconnect the system terminals 51, 52 from the module terminals 21, 22, respectively. Particularly, the BDU control unit 86 controls the conductivity state of the BDU relays 87 to be non-conductive, separating the current paths from the module terminals 21, 22 to the system terminals 51, 52. However, if one or more of the BDU relays 87 malfunctions, the BDU control unit 86 can detect, whether one of the BDU fuses 88 is blown in response to any eventual overcurrent of the battery module 20 and, if one or both of the BDU fuses 88 are blown, detect that the battery system 50 reached a safe state. In general, the BDU control unit 86 itself may be configured determine the presence of an abnormal condition in the battery disconnect unit 50 and perform or control to perform at least one countermeasure associated with the determined abnormal condition. The LV lines between the BSM 77 and the BDU control unit 86 and between the BDU control unit 86 and the BDU relays 87a, 87b and the BDU fuses 88a, 88b that are needed for sending and receiving the signals described above are presented in Fig. 3 with thin lines to illustrate the difference between HV lines and LV lines.

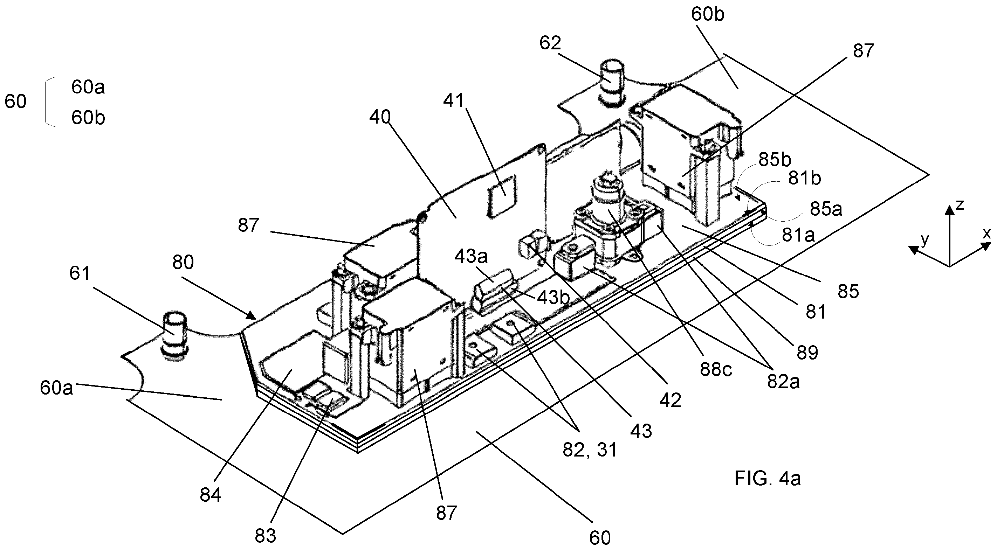

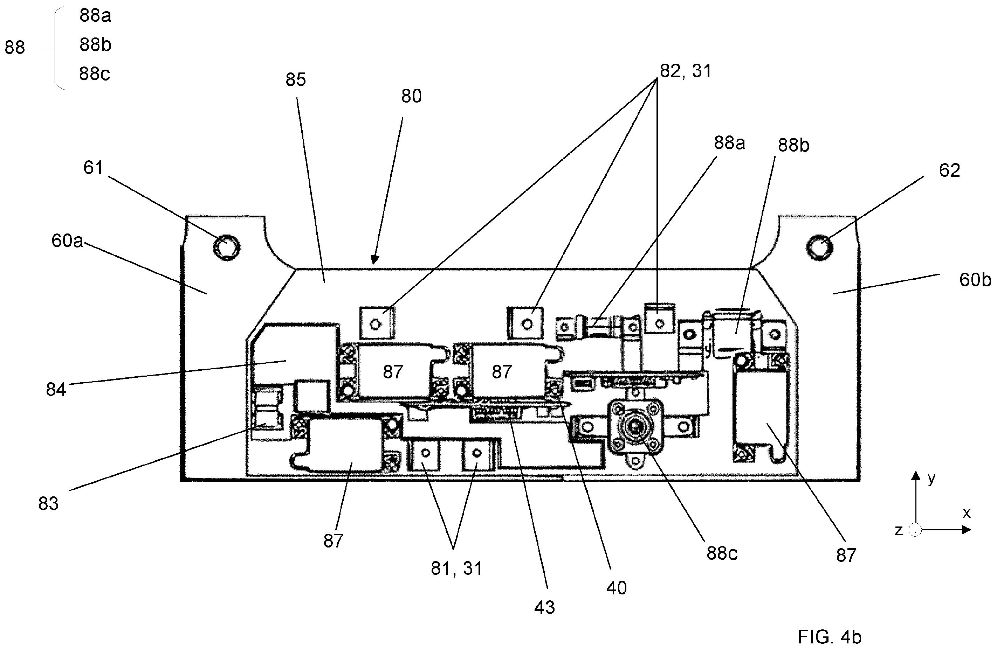

Fig. 4a and Fig. 4b both illustrate a BDU 80 according to an embodiment of the invention. Fig. 4a shows a perspective view of the BDU 80 while Fig. 4b shows a top view of the BDU 80.

A liquid cooling plate 60 is arranged on a first side 81a of the carrier plate 81. An electrically insulating thermal interface material layer 89, TIM, is arranged between the carrier plate 81 and the liquid cooling plate 60. A HV-PCB 85 is arranged on a second side 81b of the carrier plate 81, opposite to the first side 81a of the carrier plate 81. Some of the BDU components are at least partially integrated into the carrier plate 81 like the busbars 31 and are therefore only partially shown in Fig 4. The HV-PCB 85 includes a conductive layer connected to the HV-line 30. A shunt 83 and a pre-charge trace-resistor 84 are both part of the HV-PCB 85. The HV-PCB 85 further comprises second contacting means 43b configured for receiving first contacting means 43a of a LV-PCB 40. Both of the contacting means 43a, 43b are illustrated as parts of a PCB-connector 43. The BDU busbars 31 are partially integrated in the carrier plate 81, a portion of each of the busbars being exposed, and forming busbar connection areas 82.

The further BDU components are arranged on a second side 85b of the HV-PCB 85 and the HV-PCB 85 is arranged on the second side 81b of the carrier plate 81 such that the first side 85a of the HV-PCB 85 is disposed on the second side 81b of the carrier plate 81, wherein the first side 85a of the HV-PCB 85 is opposite to the second side 85b of the HV-PCB 85.

Some of the HV BDU components like the BDU relays 87 and the BDU fuses 88a, 88b, 88c, are mounted onto mounting sockets 82a that are disposed adjacent busbar connection areas 82, establishing connections between two of the BDU busbars respectively and data connections to the LV-PCB 40 for measured sensor data of the HV BDU components. The preferred embodiment of the present invention illustrated in Fig. 4 comprises three BDU fuses 88a, 88b, 88c, each of them connecting two of the BDU busbars. The BDU fuse 88c may be a Pyrofuse and the BDU fuses 88a and 88b may be melting type fuses.

The LV components of the BDU 80 are installed on the LV-PCB 40 that is connected to the HV-PCB 85 via the PCB connector 43. The LV-PCB comprises LV electronics 42 of the BDU 80 and a CPU 41 of the BDU control unit 86. The LV components of the BDU 80 that are installed on the LV-PCB 40 comprise the BDU control unit 86 and the corresponding wiring as shown in Fig. 3.

The liquid cooling plate 60 form-fits on a first side 81a of the carrier plate 81. It comprises a cooling inlet 61 and a cooling outlet 62. The cooling liquid flows through a cavity of the liquid cooling plate 60, preferably through a plurality of flow channels inside the liquid cooling plate 60, from the cooling inlet 61 to the cooling outlet 62, cooling the carrier plate 81 with the integrated busbars 31a, 31b and the HV-PCB 85. This leads to a cold side 60a of the liquid cooling plate 60 on the side of the cooling inlet 61 and a hot side 60b of the liquid cooling plate 60 on the side of the cooling outlet 62.

The busbars 31a, 31b are electrically and thermally conducting, and hence the busbars 31a, 31b provide a thermal contact to the BDU components that are mounted on the second side of the carrier plate 81, such that the BDU components upon the operation of the battery system 50, release heat energy and transfer the released heat energy to the busbars 31a, 31b by means of conduction.

The BDU components that are mounted on the second side of the carrier plate 81 are being equally cooled as a result of this arrangement, especially the HV components like the BDU relays 87. As per requirements of the battery system 50 in an electric vehicle, a current is passed through the BDU relays 87. The BDU relays 87 have an internal resistance, as result of which heat is generated. Hence, during the operation of the battery system 50, especially, the BDU relays 87, release heat energy, as result of which the temperature of the battery system 50 gets increased. This would have an adverse effect on the performance of the battery system 50 as a whole. Hence, it is necessary to transfer the released heat by means of cooling.

The preferred embodiment of the present invention illustrated in Fig. 4 is of advantage, because it enables for an efficient manufacture of the BDU 80, which also comprises a compact structure of the BDU 80. The preferred embodiment is especially of advantage when some of the BDU components, for example the BDU fuses 88a, 88b, 88c need to be replaced, for it may be easily disconnected from the busbar connection areas and replaced. Also the LV-PCB may be easily replaced, for example in case of an update, due to the PCB connector 43.

### Reference signs

- 2: battery case
- 3: cap assembly
- 4: cap plate
- 10: battery cell
- 11: positive terminal
- 12: negative terminal
- 13: injection hole
- 14: vent hole
- 15: notch
- 16: vent member
- 18: battery module busbars
- 20: battery module
- 21: first module terminal
- 22: second module terminal
- 23: heat exchange member
- 24: elastic member
- 25: support member
- 26: end plate
- 27: connection plate
- 28: fastening portion
- 29: bolt
- 30: HV line
- 30a: first HV line
- 30b: second HV line
- 30c: first high current cable
- 30d: second high current cable
- 31: BDU busbar
- 31a: first BDU busbar
- 31b: second BDU busbar
- 40: LV-PCB
- 41: CPU
- 42: LV BDU electronics
- 43: PCB connector
- 43a: first contacting means
- 43b: second contacting means
- 50: battery system
- 51: battery system terminal
- 52: battery system terminal
- 60: liquid cooling plate
- 60a: liquid cooling plate (cold side)
- 60b: liquid cooling plate (hot side)
- 61: cooling inlet
- 62: cooling outlet
- 70: housing
- 77: BSM
- 80: BDU
- 81: carrier plate
- 81a: first side of the carrier plate
- 81b: second side of the carrier plate
- 82: busbar connection area
- 83: shunt
- 84: pre-charge trace-resistor
- 85: HV-PCB
- 85a: first side of the HV-PCB
- 85b: second side of the HV-PCB
- 86: BDU control unit
- 87: BDU relay
- 87a: first BDU relay
- 87b: second BDU relay
- 88: BDU fuse
- 88a: first BDU fuse
- 88b: second BDU fuse
- 88c: pyrofuse
- 89: TIM

## Claims

1. A battery system (50), comprising:
a high voltage system, HV system, with a plurality of connected rechargeable battery cells (10);
a battery disconnecting unit, BDU (80), comprising a carrier plate (81), BDU relays (87) to switchably open or close a HV line (30) of the HV system, wherein the HV line (30) is at least partially integrated into the carrier plate (81), and a BDU control unit (86) adapted to control the BDU relays (87); and
a liquid cooling plate (60), wherein the liquid cooling plate (60) is arranged on a first side (81a) of the carrier plate (81),
the BDU (80) further comprises high-voltage, HV, components, including the BDU relays (87), and low-voltage, LV, components, including the BDU control unit (86),
wherein the first side of the carrier plate (81) is a flat side of the carrier plate (81) and the liquid cooling plate (60) is arranged on the first side such that a flat side of the liquid cooling plate (60) contacts the first side and
wherein the HV components and the LV components of the BDU (80) are arranged on a second side of the carrier plate (81), wherein the second side of the carrier plate (81) is opposite to the first side (81a) of the carrier plate (81).

2. The battery system (50) of claim 1, wherein the liquid cooling plate (60) comprises a cavity configured to conduct a cooling liquid, and wherein the liquid cooling plate is adapted such that the first side (81a) of the carrier plate (81) form-fits on the liquid cooling plate (60).

3. The battery system (50) according to any one of the preceding claims, further comprising a low voltage system, LV system, with an operating voltage lower than an operating voltage of the HV system, wherein the BDU control unit (86) is assembled with the LV system.

4. The battery system (50) according to any one of the preceding claims, wherein the HV-line (30) comprises a plurality of busbars (31a, 31b) that are at least partially integrated into the carrier plate (81).

5. The battery system (50) according to any one of the preceding claims, wherein the HV components of the BDU (80) comprise a high voltage printed circuit board (85), HV-PCB, disposed on the second side of the carrier plate (81), including a conductive layer connected to the HV-line (30), and the LV components of the BDU (80) comprise a low voltage printed circuit board, LV-PCB (40), wherein the HV components and the LV components of the BDU (80) are disposed on the HV-PCB (85).

6. The battery system (50) according to claim 5, wherein the HV-PCB (85) comprises a pre-charge trace-resistor (84) and wherein the pre-charge trace resistor (84) comprises a conductive trace.

7. The battery system (50) according to claim 5 or 6, wherein the HV-PCB (85) further comprises a shunt (83).

8. The battery system (50) according to any one of the claims 5 to 7, wherein the LV-PCB (40) comprises first contacting means (43a) and wherein the HV-PCB (85) comprises second contacting means (43b) configured for receiving the first contacting means (43a) for establishing a data connection between the LV-PCB (40) and the HV-PCB (85).

9. The battery system (50) according to any one of the claims 5 to 8, wherein the HV-PCB (85) comprises busbar connection areas (82), each busbar connection area (82) exposing a portion of one of the plurality of busbars (31a, 31b).

10. The battery system (50) according to any one of the claims 5 to 9, wherein the BDU components comprise at least one Pyrofuse (88c), at least one relay (87) and/or at least one melting fuse (88a, 88b).

11. The battery system (50) according to claims 9 and 10, wherein at least one relay (87) and/or fuse (88) is connecting two busbar connection areas (82) to each other.

12. The battery system (50) according to claim 8, wherein the HV-PCB (85) further comprises a plurality of data lines connecting the second contacting means (43b) and at least one mounting socket (82a) formed on the second side of the carrier plate.

13. The battery system (50) according to any one of the claims 5 to 12, wherein the BDU (80) comprises a thermally conducting and electrically isolating interface material layer (89), TIM, arranged between the liquid cooling plate (60) and the carrier plate (81) and/or between the carrier plate (81) and the HV-PCB (85).

14. An electric vehicle including a battery system (50) according to any one of the preceding claims.

## Patentansprüche

1. Batteriesystem (50), umfassend:
ein Hochspannungssystem (HV-System) mit mehreren verbundenen wiederaufladbaren Batteriezellen (10);
eine Batterietrennvorrichtung (BDU) (80), umfassend eine Trägerplatte (81), BDU-Relais (87) zum schaltbaren Öffnen oder Schließen einer HV-Leitung (30) des HV-Systems, wobei die HV-Leitung (30) zumindest teilweise in die Trägerplatte (81) integriert ist, und eine BDU-Steuereinheit (86) zum Steuern der BDU-Relais (87); und
eine Flüssigkeitskühlplatte (60), wobei die Flüssigkeitskühlplatte (60) auf einer ersten Seite (81a) der Trägerplatte (81) angeordnet ist,
wobei die BDU (80) ferner Hochspannungskomponenten (HV-Komponenten), einschließlich der BDU-Relais (87), und Niederspannungskomponenten (LV-Komponenten), einschließlich der BDU-Steuereinheit (86), umfasst,
wobei die erste Seite der Trägerplatte (81) eine flache Seite der Trägerplatte (81) und die Flüssigkeitskühlplatte (60) auf der ersten Seite so angeordnet ist, dass eine flache Seite der Flüssigkeitskühlplatte (60) mit der ersten Seite in Kontakt steht, und
wobei die HV-Komponenten und die LV-Komponenten der BDU (80) auf einer zweiten Seite der Trägerplatte (81) angeordnet sind, wobei die zweite Seite der Trägerplatte (81) der ersten Seite (81a) der Trägerplatte (81) gegenüberliegt.

2. Batteriesystem (50) nach Anspruch 1, wobei die Flüssigkeitskühlplatte (60) einen Hohlraum umfasst, der dazu konfiguriert ist, eine Kühlflüssigkeit zu leiten, und wobei die Flüssigkeitskühlplatte so ausgelegt ist, dass die erste Seite (81 a) der Trägerplatte (81) formschlüssig auf der Flüssigkeitskühlplatte (60) sitzt.

3. Batteriesystem (50) nach einem der vorstehenden Ansprüche, umfassend ferner ein Niederspannungssystem (LV-System) mit einer Betriebsspannung, die niedriger ist als eine Betriebsspannung des HV-Systems, wobei die BDU-Steuereinheit (86) mit dem LV-System zusammengebaut ist.

4. Batteriesystem (50) nach einem der vorstehenden Ansprüche, wobei die HV-Leitung (30) mehrere Sammelschienen (31a, 31b) umfasst, die zumindest teilweise in die Trägerplatte (81) integriert sind.

5. Batteriesystem (50) nach einem der vorstehenden Ansprüche, wobei die HV-Komponenten der BDU (80) eine Hochspannungs-Leiterplatte (HV-PCB) (85) umfassen, die auf der zweiten Seite der Trägerplatte (81) angeordnet ist und eine mit der HV-Leitung (30) verbundene leitfähige Schicht umfasst, während die LV-Komponenten der BDU (80) eine Niederspannungs-Leiterplatte (LV-PCB) (40) umfassen, wobei die HV-Komponenten und die LV-Komponenten der BDU (80) auf der HV-PCB (85) angeordnet sind.

6. Batteriesystem (50) nach Anspruch 5, wobei die HV-PCB (85) einen Vorladungs-Leiterbahnwiderstand (84) umfasst und wobei der Vorladungs-Leiterbahnwiderstand (84) eine leitfähige Leiterbahn umfasst.

7. Batteriesystem (50) nach Anspruch 5 oder 6, wobei die HV-PCB (85) ferner einen Shunt (83) umfasst.

8. Batteriesystem (50) nach einem der Ansprüche 5 bis 7, wobei die LV-PCB (40) erste Kontaktmittel (43a) umfasst und wobei die HV-PCB (85) zweite Kontaktmittel (43b) umfasst, die zur Aufnahme der ersten Kontaktmittel (43a) konfiguriert sind, um eine Datenverbindung zwischen der LV-PCB (40) und der HV-PCB herzustellen (85) herzustellen.

9. Batteriesystem (50) nach einem der Ansprüche 5 bis 8, wobei die HV-PCB (85) Sammelschienen-Verbindungsbereiche (82) umfasst, wobei jeder Sammelschienen-Verbindungsbereich (82) einen Abschnitt einer der mehreren Sammelschienen (31a, 31b) freilegt.

10. Batteriesystem (50) nach einem der Ansprüche 5 bis 9, wobei die BDU-Komponenten mindestens eine Pyrofuse (88c), mindestens ein Relais (87) und/oder mindestens eine Schmelzsicherung (88a, 88b) umfassen.

11. Batteriesystem (50) nach den Ansprüchen 9 und 10, wobei mindestens ein Relais (87) und/oder eine Sicherung (88) zwei Sammelschienen-Verbindungsbereiche (82) miteinander verbinden.

12. Batteriesystem (50) nach Anspruch 8, wobei die HV-PCB (85) ferner mehrere Datenleitungen, die die zweiten Kontaktmittel (43b) verbinden, und mindestens einen Montagesockel (82a) umfasst, der auf der zweiten Seite der Trägerplatte ausgebildet ist.

13. Batteriesystem (50) nach einem der Ansprüche 5 bis 12, wobei die BDU (80) eine wärmeleitende und elektrisch isolierende Grenzflächenmaterialschicht (TIM) (89) umfasst, die zwischen der Flüssigkeitskühlplatte (60) und der Trägerplatte (81) und/oder zwischen der Trägerplatte (81) und der HV-PCB (85) angeordnet ist.

14. Elektrofahrzeug mit einem Batteriesystem (50) nach einem der vorstehenden Ansprüche.

## Revendications

1. Système de batterie (50), comportant :
un système haute tension, système HT, avec une pluralité d'éléments de batterie rechargeables (10) connectés ;
une unité de déconnexion de batterie, BDU (80), comportant une plaque support (81), des relais BDU (87) pour ouvrir ou fermer de manière commutable une ligne HT (30) du système HT, dans lequel la ligne HT (30) est au moins partiellement intégrée dans la plaque support (81), et une unité de commande BDU (86) adaptée pour commander les relais BDU (87) ; et
une plaque de refroidissement liquide (60), dans lequel la plaque de refroidissement liquide (60) est agencée sur un premier côté (81a) de la plaque support (81),
la BDU (80) comporte en outre des composants haute tension, HT, incluant les relais BDU (87), et des composants basse tension, BT, incluant l'unité de commande BDU (86),
dans lequel le premier côté de la plaque support (81) est un côté plat de la plaque support (81) et la plaque de refroidissement par liquide (60) est agencée sur le premier côté de sorte qu'un côté plat de la plaque de refroidissement liquide (60) entre en contact avec le premier côté et
dans lequel les composants HT et les composants BT de la BDU (80) sont agencés sur un second côté de la plaque support (81), dans lequel le second côté de la plaque support (81) est opposé au premier côté (81a) de la plaque support (81).

2. Système de batterie (50) selon la revendication 1, dans lequel la plaque de refroidissement liquide (60) comporte une cavité configurée pour conduire un liquide de refroidissement, et dans lequel la plaque de refroidissement liquide est adaptée de sorte que le premier côté (81a) de la plaque support (81) s'adapte sur la plaque de refroidissement liquide (60).

3. Système de batterie (50) selon l'une quelconque des revendications précédentes, comportant en outre un système basse tension, système BT, avec une tension de fonctionnement inférieure à une tension de fonctionnement du système HT, dans lequel l'unité de commande BDU (86) est assemblée avec le système BT.

4. Système de batterie (50) selon l'une quelconque des revendications précédentes, dans lequel la ligne HT (30) comporte une pluralité de barres omnibus (31a, 31b) qui sont au moins partiellement intégrées dans la plaque support (81).

5. Système de batterie (50) selon l'une quelconque des revendications précédentes, dans lequel les composants HT de la BDU (80) comportent une carte à circuit imprimé haute tension (85), HT-PCB, disposée sur le second côté de la plaque support (81), incluant une couche conductrice connectée à la ligne HT (30), et les composants BT de la BDU (80) comportent une carte à circuit imprimé basse tension, BT-PCB, (40) dans lequel les composants HT et les composants BT de la BDU (80) sont disposés sur la HT-PCB (85).

6. Système de batterie (50) selon la revendication 5, dans lequel la HT-PCB (85) comporte une résistance de trace de précharge (84) et dans lequel la résistance de trace de précharge (84) comporte une trace conductrice.

7. Système de batterie (50) selon la revendication 5 ou 6, dans lequel la HT-PCB (85) comporte en outre un shunt (83).

8. Système de batterie (50) selon l'une quelconque des revendications 5 à 7, dans lequel la BT-PCB (40) comporte un premier moyen de mise en contact (43a) et dans lequel la HT-PCB (85) comporte un second moyen de mise en contact (43b) configuré pour recevoir le premier moyen de mise en contact (43a) pour établir une connexion de données entre la BT-PCB (40) et la HT-PCB (85).

9. Système de batterie (50) selon l'une quelconque des revendications 5 à 8, dans lequel la HT-PCB (85) comporte des zones de connexion de barre omnibus (82), chaque zone de connexion de barre omnibus (82) exposant une partie de l'une de la pluralité de barres omnibus (31a, 31b).

10. Système de batterie (50) selon l'une quelconque des revendications 5 à 9, dans lequel les composants BDU comportent au moins un fusible pyrotechnique (88c), au moins un relais (87) et/ou au moins un fusible à fusion (88a, 88b).

11. Système de batterie (50) selon les revendications 9 et 10, dans lequel au moins un relais (87) et/ou fusible (88) connecte(nt) deux zones de connexion de barre omnibus (82) entre elles.

12. Système de batterie (50) selon la revendication 8, dans lequel la HT-PCB (85) comporte en outre une pluralité de lignes de données connectant le second moyen de mise en contact (43b) et au moins une douille de montage (82a) formée sur le second côté de la plaque support.

13. Système de batterie (50) selon l'une quelconque des revendications 5 à 12, dans lequel la BDU (80) comporte une couche de matériau d'interface thermoconductrice et électriquement isolante (89), TIM, agencée entre la plaque de refroidissement liquide (60) et la plaque support (81) et/ou entre la plaque support (81) et la HT-PCB (85).

14. Véhicule électrique comportant un système de batterie (50) selon l'une quelconque des revendications précédentes.
